# EUROPÄISCHE PATENTSCHRIFT

(11) **EP 0 404 995 B1**
(45) Veröffentlichungstag und Bekanntmachung des Hinweises auf die Patenterteilung: **31.08.1994**
(21) Anmeldenummer: 89111980.2
(22) Anmeldetag: 30.06.1989
(51) Int. Cl.: G06F 11/00, G06F 11/20, G11C 5/00, G11C 7/00, G11C 5/14, G11C 11/409

(54) **Integrierte Schaltungsanordnung**
Integrated-circuit array
Circuit intégré

(43) Veröffentlichungstag der Anmeldung: 02.01.1991
(73) Patentinhaber: SIEMENS AKTIENGESELLSCHAFT, 80333 München (DE)
(72) Erfinder: Pribyl, Wolfgang, Dr., A-8043 Graz (AT)

(56) Entgegenhaltungen:
- EP-A- 0 086 310
- GB-A- 2 067 836
- GB-A- 2 209 871

## Beschreibung

Die Erfindung betrifft eine integrierte Schaltungsanordnung nach dem Oberbegriff des Patentanspruches 1.

Moderne integrierte Halbleiterschaltungen sind häufig so ausgelegt, daß sie prinzipiell in wenigstens zwei verschiedenen Betriebsarten betreibbar sind. Beispielsweise sind integrierte Halbleiterspeicher teilweise so ausgelegt, daß sie im sogenannten Nibble-Mode oder im sogenannten Page-Mode betreibbar sind. Eine andere Variante stellt die Wahlmöglichkeit zwischen verschiedenen Organisationsformen von Halbleiterspeichern dar. Dabei ist bei einem 16MBit-Speicher beispielsweise wählbar, ob er in der Organisationsform "16MBit x 1 Bit Datenbreite" betreibbar ist oder in der Organisationsform "4MBit x 4 Bit Datenbreite". Die Festlegung der Auswahl, d.h. die Konfiguration, erfolgt dabei irreversibel durch den Hersteller der Halbleiterschaltkreise, im allgemeinen in der Herstellungsphase oder vor Einbau des Chips der Halbleiterschaltung in ein Gehäuse. Dazu kann beispielsweise ein auf dem Halbleiterchip speziell vorgesehenes Anschlußpad entweder unbeschaltet bleiben oder mit einem der Versorgungspotentialanschlüsse verbunden werden.

Für denselben Zweck sind jedoch auch Konfigurationsschaltungen bekannt, die meist eine unterbrechbare sogenannte "laser fuse" oder eine spezielle, ebenfalls unterbrechbare, Leiterbahn zur Auswahl der gewünschten Konfiguration enthalten. Damit wird im Betrieb ein sogenanntes Konfigurationssignal erzeugt, das dann die gewählte Betriebsart der gesamten Halbleiterschaltung auswählt. Eine derartige Konfigurationsschaltung ist beispielsweise aus Dokument GB-A-2 067 836 bekannt.

Um die gesamte Halbleiterschaltung jedoch in allen Konfigurationszuständen testen zu können, ist meist noch ein Anschlußmittel vorgesehen (häufig als Anschlußpad ausgestaltet, es ist jedoch auch eine spezielle Leiterbahn zum Aufsetzen einer Prüfspitze oder eine Anordnung zum Einkoppeln eines Lichtstrahls möglich), über das in einem solchen Testfall ein Steuerpotential anlegbar ist.

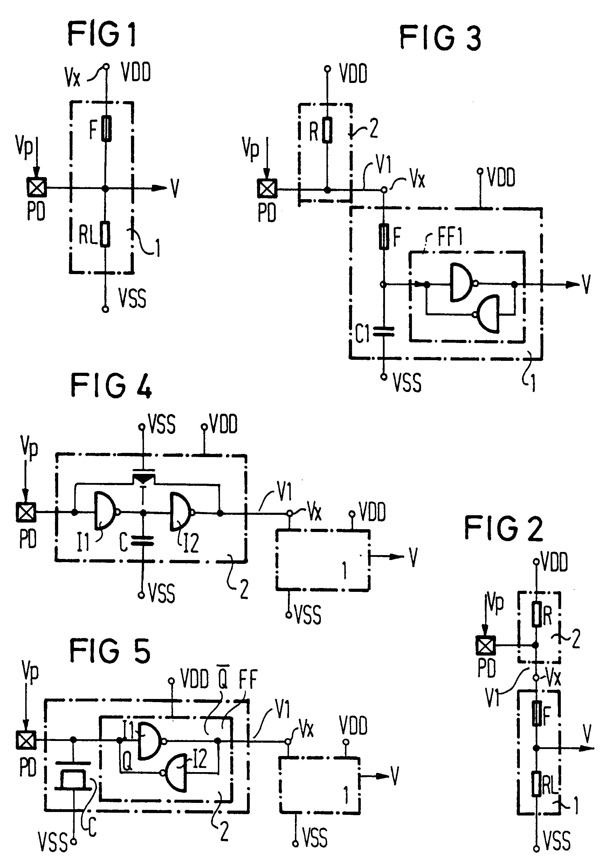

Eine entsprechende gattungsgemäße integrierte Schaltungsanordnung mit einer Konfigurationsschaltung und einem Anschlußmittel ist in FIG 1 gezeigt (wird noch erläutert). Sie hat jedoch den Nachteil, daß bei Anlegen des Steuerpotentials je nach dessen Potentialwert ein hoher Strom über die laser fuse (bzw. die unterbrechbare Leiterbahn, je nach Ausgestaltung) zu einem Versorgungspotential der Konfigurationsschaltung fließt.

Aufgabe der vorliegenden Erfindung ist es, eine gattungsgemäße integrierte Schaltungsanordnung so weiterzubilden, daß bei Anlegen dem Steuerpotentials in jedem Fall nur ein geringer Stromfluß auftritt.

Diese Aufgabe wird bei einer gattungsgemäßen Anordnung gelöst durch die kennzeichnenden Merkmale des Patentanspruches 1. Vorteilhafte Aus- und Weiterbildungen sind in Unteransprüchen gekennzeichnet.

Im folgenden wird die Erfindung anhand von FIG näher beschrieben. Es zeigen:
FIG 1 eine Anordnung nach dem Stande der Technik,
die FIG 2 bis 5 verschiedene Ausführungsformen der Erfindung.

Zunächst wird FIG 1 als Stand der Technik erläutert. Eine Konfigurationsschaltung 1 enthält beispielsweise eine laser fuse F und in Serie dazu einen Lastwiderstand RL. Beide sind zwischen zwei Potentiale, meist Versorgungspotentiale einer integrierten Halbleiterschaltung, innerhalb derer die Konfigurationsschaltung 1 angeordnet ist, geschaltet. Der Potentialanschluß, mit dem die laser fuse F verbunden ist, ist mit Vx bezeichnet. An einem gemeinsamen Verbindungspunkt von laser fuse F und Lastwiderstand RL entsteht ein Konfigurationssignal V, dessen Wert davon abhängig ist, ob die laser fuse F durchtrennt ist oder nicht. Mit dem gemeinsamen Verbindungspunkt (und somit auch mit dem Konfigurationssignal V) ist auch ein Anschlußmittel PD für ein Steuerpotential Vp verbunden. Im Normalbetrieb liegt das Steuerpotential Vp nicht an, jedoch im Testbetrieb. In einem ersten Testfall weist das Steuerpotential Vp denselben Wert auf wie dasjenige Potential, mit dem die laser fuse F verbunden ist (mit VDD bezeichnet). Dann tritt kein Stromfluß auf durch die laser fuse F, jedoch ein geringer Stromfluß durch den typischerweise hochohmigen Lastwiderstand RL. In einem zweiten Testfall weist das Steuerpotential Vp jedoch denselben Wert auf wie dasjenige Potential, mit dem der Lastwiderstand RL verbunden ist (mit VSS bezeichnet). Damit tritt zwar kein Stromfluß auf durch den Lastwiderstand RL, jedoch ein sehr hoher Stromfluß durch die laser fuse F, da diese üblicherweise niederohmig ausgelegt ist.

Erfindungsgemäß ist dagegen vorgesehen, wie in den FIG 2 bis 5 gezeigt, daß das Anschlußmittel PD unter Verwendung einer elektronischen Schaltung 2 mit dem Potentialanschluß Vx der Konfigurationsschaltung 1 verbunden ist (mit dem Potentialanschluß Vx ist ebenfalls eine bereits beschriebene laser fuse F (oder ein damit gleichwirkendes Element wie eine auftrennbare Leiterbahn) der Konfigurationsschaltung 1 verbunden). Damit ist sichergestellt, daß im nicht-aufgetrennten Zustand der laser fuse F unter keiner Bedingung ein hoher Stromfluß über die laser fuse F und somit über das Anschlußmittel PD stattfinden kann.

Gemäß der Ausführungsform nach FIG 2 enthält die elektronische Schaltung 2 ein Lastelement R. Dieses ist einerseits mit einem Versorgungspotential VDD verbunden und andererseits sowohl mit dem Potentialanschluß Vx der Konfigurationsschaltung 1 wie auch mit dem Anschlußmittel PD. Dadurch entsteht im Betrieb am Potentialanschluß Vx ein Hilfspotential V1. dieses hat im Normalbetrieb (es liegt kein Steuerpotential Vp an) in etwa den Wert des Versorgungspotentials VDD. Liegt jedoch (im Testfall) am Anschlußmittel PD das Steuerpotential Vp an, so ist das Hilfspotential V1 gleich dem Steuerpotential Vp. Das Lastelement R kann auf mehrere Arten reallisiert sein, beispielsweise als ohmischer Widerstand oder als Widerstand geschalteter Transistor. Die Konfigurationsschaltung 1 ist dieselbe wie in FIG 1. Bei der Ausführungsform nach FIG 2 ist darauf zu achten, daß das Lastelement R zwar hochohmig auszuführen ist, jedoch niederohmiger als der Lastwiderstand RL, damit sich im Normalbetrieb ein Hilfspotential V1 einstellen kann, das sich wertemäßig nur gering vom Versorgungspotential VDD unterscheidet (ohmischer Spannungsteiler, gebildet aus Lastelement R, laser fuse F, Lastwiderstand RL!).

FIG 3 zeigt die selbe elektronische Schaltung 2 wie FIG 2. Die Konfigurationsschaltung 1 enthält jedoch anstelle des Lastwiderstandes RL nach den FIG 1 und 2 ein Flip-Flop FF1 und eine Kapazität C1.

Bei der Ausführungsform nach FIG 4 ist die elektronische Schaltung 2 zwischen dem Anschlußmittel PD und dem Potentialanschluß Vx angeordnet. Sie enthält wenigstens ein in Serie zueinander geschaltetes Paar von Invertern I1,I2. Der Ausgang des einen Inverters I1 ist über eine Kapazität C mit einem ersten Versorgungspotential VSS der Schaltungsanordnung verbunden. Der Ausgang des anderen Inverters I2 ist über die Source-Drain-Strecke eines Transistors T mit dem Eingang des einen Inverters I1 verbunden. Das Gate des Transistors T ist mit dem ersten Versorgungspotential VSS verbunden.

Vorzugsweise ist der Transistor T von einem solchen Kanaltyp, bei dem im elektrisch leitenden Zustand kein Spannungsabfall entlang seiner Source-Drain-Strecke in Höhe seiner Einsatzspannung Vₜₕ auftritt, wenn am Gate, wie gemäß der Erfindung beschaltet, das erste Versorgungspotential VSS anliegt und an seiner Source ein vom ersten Versorgungspotential VSS unterschiedliches Potential anliegt, welches üblicherweise ein zweites Versorgungspotential VDD der integrierten Schaltungsanordnung ist. Geht man, wie allgemein üblich, davon aus, daß das erste Versorgungspotential VSS 0 V beträgt und das zweite Versorgungspotential VDD typischerweise 5 V, so ist der Transistor T demzufolge vom p-Kanal-Typ. Dreht man die Polaritäten der Versorgungspotentiale VSS,VDD jedoch um (nicht dargestellt, jedoch möglich), so ist der Transistor T demzufolge vom n-Kanal-Typ. Die Kapazität C ist vorzugsweise als Kondensator oder Varaktor ausgebildet.

Die elektronische Schaltung 2 funktioniert folgendermaßen: Im Normalfall, in dem am Anschlußmittel PD kein Steuerpotential Vp anliegt, liegt der Eingang des anderen Inverters I2 wegen seiner kapazitiven Ankopplung an das erste Versorgungspotential VSS zunächst ebenfalls auf dem ersten Versorgungspotential VSS ("Power-on"-Phase, bei der die Kapazität C entladen ist). Am Potentialanschluß Vx stellt sich demzufolge ein Hilfspotential V1 ein, das gleich dem zweiten Versorgungspotential VDD ist. Der Transistor T ist somit elektrisch leitend, das zweite Versorgungspotential VDD liegt auch am Eingang des einen Inverters I1 an. Dies wiederum bewirkt ein Festklemmen des Eingangs des anderen Inverters I2 auf dem ersten Versorgungspotential VSS.

Liegt am Anschlußmittel PD ein Steuerpotential Vp an mit einem Wert, der in etwa gleich dem zweiten Versorgungspotential VDD ist, so herrschen dieselben elektrischen Verhältnisse und Zustände, wie für den Normalfall vorstehend bereits beschrieben.

Liegt am Anschlußmittel PD jedoch ein Steuerpotential Vp an mit einem Wert gleich dem ersten Versorgungspotential VSS, so weist das Hilfspotential V1 ebenfalls diesen Wert auf, was bezüglich des Konfigurationssignals V dieselbe Wirkung hat, wie wenn die laser fuse F der Konfigurationsschaltung 1 aufgetrennt wäre. Die durch das Konfigurationssignal V angesteuerte (nicht dargestellte) Halbleiterschaltung kann nun zu Testzwecken so betrieben werden, wie wenn eine bleibende Konfigurationsänderung (analog dem Auftrennen der laser fuse F) vorgenommen wäre. Im Gegensatz zu einer bleibenden Konfigurationsänderung mittels laser fuse F ist jedoch diese Konfigurationsänderung reversibel durch Änderung des Steuerpotentials Vp oder durch Entfernen des Steuerpotentials Vp.

FIG 5 zeigt eine weitere vorteilhafte Ausführungsform der Erfindung. Dabei ist die elektronische Schaltung 2 ebenfalls, wie bei FIG 4, zwischen dem Anschlußmittel PD und dem Potentialanschluß Vx angeordnet. Sie enthält jedoch vorteilhafterweise ein Flip-Flop FF. Dieses weist eine elektrische Vorzugslage auf, die beim Einschalten der bereits genannten ersten und zweiten Versorgungspotentiale VSS,VDD in dem Fall, in dem das Steuerpotential Vp nicht am Anschlußmittel PD anliegt, bewirkt, daß der nicht-invertierende Ausgang Q, der nicht mit dem Potentialanschluß Vx verbunden ist, einen elektrischen Zustand aufweist, der gleich dem ersten Versorgungspotential VSS ist. Demzufolge weist der invertierende Ausgang Q̅ des Flip-Flops FF das obengenannte zweite Versorgungspotential VDD auf. Dies stellt den Normalbetrieb dar, bei dem der Zustand des Konfigurationssignals V lediglich davon abhängt, ob die laser fuse F der Konfigurationsschaltung 1 aufgetrennt ist oder nicht.

Um die elektrische Vorzugslage realisieren zu können, enthält das Flip-Flop FF vorzugsweise zwei antiparallel geschaltete Inverter I1,I2, insbesondere vom CMOS-Typ, die unterschiedlich große Schaltzeiten t1,t2 aufweisen. Dabei ist es günstig, wenn die eine Schaltzeit t1 höchstens 1/2 mal so groß ist wie die andere Schaltzeit t2. Das Einnehmen der Vorzugslage läßt sich auch unterstützen, wenn das Flip-Flop FF, wie in FIG 5 ebenfalls gezeigt, eingangsseitig mit einer Kapazität C gegen das erste Versorgungspotential VSS beschaltet ist. Der Wert des Konfigurationssignals V wird in dem Fall, in dem am Anschlußmittel PD kein Steuerpotential Vp anliegt, allein durch den Zustand der laser fuse F bestimmt.

Liegt am Anschlußmittel PD das Steuerpotential Vp an mit einem Potentialwert, der gleich dem ersten Versorgungspotential VSS ist, so weist das Hilfssignal V1 den Wert des zweiten Versorgungspotentials VDD auf. Auch in diesem Fall wird der Wert des Konfigurationssignales V allein durch den Zustand der laser fuse F bestimmt. Im nicht-aufgetrennten Zustand der laser fuse F bewirkt das Konfigurationssignal V demzufolge, daß die angeschlossene Halbleiterschaltung in ihrer ersten Betriebsart betreibbar ist.

Liegt am Anschlußmittel PD jedoch das Steuerpotential Vp an mit einem Potentialwert, der gleich dem zweiten Versorgungspotential VDD ist (dies ist nur sinnvoll, wenn die laser fuse F nicht aufgetrennt ist), dann nimmt das Hilfspotential V1 am Potentialanschluß Vx den Wert des ersten Versorgungspotentials VSS an. Dies hat hinsichtlich des Konfigurationssignales V dieselbe Wirkung, wie wenn die laser fuse F aufgetrennt wäre. Die daran angeschlossene Halbleiterschaltung ist somit in ihrer zweiten Betriebsart (Konfiguration) betreibbar, was jedoch (im Gegensatz zur Situation bei einer aufgetrennten laser fuse F) reversibel ist.

Die vorliegende Erfindung ermöglicht also, ebenso wie eine Schaltungsanordnung nach dem Stande der Technik, ein Betreiben einer an die integrierte Schaltungsanordnung angeschlossenen integrierten Halbleiterschaltung in verschiedenen Betriebsarten (Konfigurationen), wobei ein Wechsel von einer Betriebsart zu einer anderen Betriebsart möglich ist und umgekehrt. Es tritt jedoch ein wesentlich geringerer Stromverbrauch auf als beim Stande der Technik: Während beim Stande der Technik (FIG 1) bei Anlegen des ersten Versorgungspotentials VSS als Steuerpotential Vp über die laser fuse F der Konfigurationsschaltung 1 ein relativ hoher Strom auftritt (laser fuse F ist bekanntlich relativ niederohmig), tritt bei Anlegen desselben Steuerpotentials Vp über das Lastelement R der elektronischen Schaltung 2 nach den FIG 2,3 ein geringer Stromfluß auf, da das Lastelement R hochohmig ist. Bei den Ausführungsformen nach den FIG 4,5 ist dieser Stromfluß nochmals deutlich geringer, da die Inverter I1,I2, wie bei Invertern allgemein bekannt (insbesondere bei solchen aus MOS-Transistoren, speziell CMOS-Invertern), eine sehr geringe Eingangsstromaufnahme haben. Selbst bei leitendem Transistor T in FIG 4 tritt nur ein geringer Stromfluß auf, der in diesem Fall von der Stromaufnahme der Konfigurationsschaltung 1 am Potentialanschluß Vx bestimmt wird.

## Patentansprüche

1. Integrierte Schaltungsanordnung mit einer Konfigurationsschaltung (1), die ein an einem Potentialanschluß (Vx) geschaltenes fuse Element (F) wie ein laser fuse oder ein damit gleichwirkendes Element wie eine auftrennbare Leiterbahn aufweist und mit einem Anschlußmittel (PD) für ein Steuerpotential (Vp) das dazu dient die gesamte Konfigurationsschaltung in allen Konfigurationszuständen testen zu können, **dadurch gekennzeichnet**, daß das Anschlußmittel (PD) unter Verwendung einer elektronischen Schaltung (2) die jeweils ein Hilfspotential (V1) erzeugt, mit dem Potentialanschluß (Vx) verbunden ist so daß bei Anlegen des Steuerpotentials in jedem Fall nur ein geringer Stromfluß über das geschaltene fuse Element (F) und somit über das Anschlußmittel (PD) Auftritt.

2. Integrierte Schaltungsanordnung nach Anspruch 1, **dadurch gekennzeichnet**, daß die elektronische Schaltung (2) ein Lastelement (R) enthält, das einerseits mit dem Anschlußmittel (PD) und dem Potentialanschluß (Vx) und andererseits mit einem Versorgungspotential (VDD) verbunden ist.

3. Integrierte Schaltungsanordnung nach Anspruch 1, **dadurch gekennzeichnet**,
- daß die elektronische Schaltung (2) zwischen dem Anschlußmittel (PD) und dem Potentialanschluß (Vx) angeordnet ist,
- daß die elektronische Schaltung (2) wenigstens ein in Serie geschaltetes Paar von Invertern (I1,I2) enthält,
- daß der Ausgang des einen Inverters (I1) über eine Kapazität (C) mit einem ersten Versorgungspotential (VSS) verbunden ist,
- daß der Ausgang des anderen Inverters (I2) über einen Transistor (T) mit dem Eingang des einen Inverters (I1) verbunden ist und
- daß das Gate des Transistors (T) ebenfalls mit dem ersten Versorgungspotential (VSS) verbunden ist.

4. Integrierte Schaltungsanordnung nach Anspruch 3, **dadurch gekennzeichnet**, daß der Transistor (T) von einem solchen Kanaltyp ist, bei dem im elektrisch leitenden Zustand kein Spannungsabfall in Höhe seiner Einsatzspannung (Vₜₕ) auftritt, wenn am Gate das erste Versorgungspotential (VSS) anliegt und an seiner Source ein vom ersten Versorgungspotential (VSS) unterschiedliches Potential anliegt.

5. Integrierte Schaltungsanordnung nach Anspruch 1, **dadurch gekennzeichnet**, daß die elektronische Schaltung (2) zwischen dem Anschlußmittel (PD) und dem Potentialanschluß (Vx) angeordnet ist und daß die elektronische Schaltung (2) ein Flip-Flop (FF) enthält mit einer elektrischen Vorzugslage, die bewirkt, daß bei Einschalten einer Versorgungsspannung in dem Fall, in dem das Steuerpotential (Vp) nicht am Anschlußmittel (PD) anliegt, der nicht mit dem Potentialanschluß (Vx) verbundene, nichtinvertierende Ausgang (Q) des Flip-Flops (FF) einen Zustand aufweist, der gleich einem ersten Versorgungspotential (VSS) ist.

6. Integrierte Schaltungsanordnung nach Anspruch 5, **dadurch gekennzeichnet**, daß das Flip-Flop (FF) zwei antiparallel geschaltete Inverter (I1,I2) enthält, die unterschiedlich große Schaltzeiten (t1,t2) aufweisen.

7. Integrierte Schaltungsanordnung nach Anspruch 6, **dadurch gekennzeichnet**, daß die Inverter (I1,I2) CMOS-Inverter sind.

8. Integrierte Schaltungsanordnung nach Anspruch 6 oder 7, **dadurch gekennzeichnet**, daß die eine Schaltzeit (t1) höchstens 1/2 mal so groß ist wie die andere Schaltzeit (t2).

9. Integrierte Schaltungsanordnung nach einem der Ansprüche 5 bis 8, **dadurch gekennzeichnet**, daß das Flip-Flop (FF) eingangsseitig mit einer Kapazität (C) gegen das erste Versorgungspotential (VSS) beschaltet ist.

10. Integrierte Schaltungsanordnung nach einem der Ansprüche 3, 4 oder 9, **dadurch gekennzeichnet**, daß die Kapazität (C) ein Varaktor oder ein Kondensator ist.

## Claims

1. Integrated circuit arrangement having a configuration circuit (1) which exhibits, connected to a potential connection (Vx), a fuse element (F) such as a laser fuse or an element of action equivalent thereto, such as an interruptible conductor track, and having a connecting means (PD) for a control potential (Vp), which serves the purpose of being able to test the entire configuration circuit in all configuration conditions, characterized in that the connecting means (PD) is connected to the potential connection (Vx) with the use of an electronic circuit (2) which generates in each instance an auxiliary potential (V1), so that on application of the control potential in each case only a small current flow [lacuna] via the connected fuse element (F) and thus via the connecting means.

2. Integrated circuit arrangement according to Claim 1, characterized in that the electronic circuit (2) includes a load element (R), which is connected on the one hand to the connecting means (PD) and the potential connection (Vx) and on the other hand to a supply potential (VDD).

3. Integrated circuit arrangement according to Claim 1, characterized in that
- the electronic circuit (2) is disposed between the connecting means (PD) and the potential connection (Vx),
- the electronic circuit (2) includes at least one pair of inverters (I1, I2) which is connected in series,
- the output of the one inverter (I1) is connected via a capacitance (C) to a first supply potential (VSS),
- the output of the other inverter (I2) is connected via a transistor (T) to the input of the one inverter (I1), and
- the gate of the transistor (T) is likewise connected to the first supply potential (VSS).

4. Integrated circuit arrangement according to Claim 3, characterized in that the transistor (T) is of the channel type in the case of which, in the electrically conductive condition, no voltage drop at the level of its cut-off voltage (Vₜₕ) occurs when the first supply potential (VSS) is present at the gate and a potential different from the first supply potential (VSS) is present at its source.

5. Integrated circuit arrangement according to Claim 1, characterized in that the electronic circuit (2) is disposed between the connecting means (PD) and the potential connection (Vx), and in that the electronic circuit (2) includes a flip-flop (FF) having an electrical preferential position which, when a supply voltage is switched on in the case in which the control potential (Vp) is not present at the connecting means (PD), causes the non-inverting output (Q), which is not connected to the potential connection (Vx), of the flip-flop (FF) to exhibit a condition which is equal to a first supply potential (VSS).

6. Integrated circuit arrangement according to Claim 5, characterized in that the flip-flop (FF) includes two antiparallel-connected inverters (I1, I2) which exhibit switching times (t1, t2) of differing magnitude.

7. Intregrated circuit arrangement according to Claim 6, characterized in that the inverters (I1, I2) are CMOS inverters.

8. Integrated circuit arrangement according to Claim 6 or 7, characterized in that the one switching time (t1) is at most half as great as the other switching time (t2).

9. Integrated circuit arrangement according to one of Claims 5 to 8, characterized in that the flip-flop (FF) is connected on the input side to a capacitance (C) against the first supply potential (VSS).

10. Integrated circuit arrangement according to one of Claims 3, 4 or 9, characterized in that the capacitance (C) is a varactor or a capacitor.

## Revendications

1. Circuit intégré doté d'un circuit (1) de configuration, qui comporte un élément (F) de fusible branché tel qu'un fusible laser ou un élément équivalent à celui-ci tel qu'une piste d'interconnexion pouvant être ouverte, connecté à une borne (Vx) de potentiel, et d'un moyen (PD) de branchement à un potentiel (Vp) de commande, destiné à pouvoir faire l'essai de l'ensemble du circuit de configuration dans tous les états de configuration, caractérisé en ce que le moyen(PD) de branchement est connecté à une borne (Vx) de potentiel, en utilisant un circuit électronique, produisant dans tous les cas, un potentiel (V1) auxiliaire de sorte que lorsque l'on applique le potentiel de commande il ne passe dans chaque cas qu'un petit courant par l'élément (F) de fusible branché et de ce fait parr le moyen (PD) de branchement.

2. Circuit intégré selon la revendication 1, caractérisé en ce que le circuit (2) électronique comporte un élément (R) de charge qui est connecté d'un côté au moyen (PD) de branchement et à la borne (Vx) de potentiel, et de l'autre côté à un potentiel (VDD) d'alimentation.

3. Circuit intégré selon la revendication 1, caractérisé en ce que
- le circuit (2) électronique est disposé entre le moyen (PD) de branchement et la borne (Vx) de potentiel,
- le circuit (2) électronique comporte au moins une paire d'inverseurs (I1, I2) branchés en série,
- la sortie de l'un (I1) des inverseurs est connectée par l'intermédiaire d'une capacité (C) à un premier potentiel (VSS) d'alimentation,
- la sortie de l'autre inverseur (I2) est connectée par l'intermédiaire d'un transistor (T) à l'entrée de l'un (I1) des inverseurs,
- la grille du transistor est également connectée au premier potentiel (VSS) d'alimentation.

4. Circuit intégré selon la revendication 3, caractérisé en ce que le transistor (T) a un type de canal, dans lequel il ne se produit pas, lorsqu'il est à l'état conducteur d'électricité, de chute de tension ayant la grandeur de sa tension (Vth) de blocage, lorsque le premier potentiel (VSS) d'alimentation (VSS) est appliqué à la grille et lorsqu'un potentiel différent du premier potentiel (VSS) est appliqué à sa source.

5. Circuit intégré selon la revendication 1, caractérisé en ce que le circuit (2) électronique est disposé entre le moyen (PD) de branchement et la borne (Vx) de potentiel et le circuit (2) électronique comprend une bascule (FF) ayant une position électrique préférée qui fait en sorte que, lors de l'introduction dans le circuit d'une tension d'alimentation dans le cas où le potentiel (Vp) de commande n'est pas appliqué au moyen (PD) de branchement, la sortie (Q) non inversante de la bascule (FF), connectée à la borne (Vx) de potentiel, a un état qui est égal à un premier potentiel (VSS) d'alimentation.

6. Circuit intégré selon la revendication 5, caractérisé en ce que la bascule (FF) comporte deux inverseurs (I1, I2) qui sont branchés antiparallèlement et qui ont des temps (t1, t2) de commutation de valeur différente.

7. Circuit intégré selon la revendication 6, caractérisé en ce que les inverseurs (I1, I2) sont des inverseurs CMOS.

8. Circuit intégré suivant la revendication 6 ou 7, caractérisé en ce que l'un des temps (t1) de commutation est au plus égal à la moitié de l'autre temps (t2) de commutation.

9. Circuit intégré selon l'une des revendications 5 à 8, caractérisé en ce qu'à la bascule (FF) est branchée du côté entrée une capacité (C) face au premier potentiel (VSS) d'alimentation.

10. Circuit intégré selon l'une des revendications 3, 4 ou 9, caractérisé en ce que la capacité (C) est un varactor ou un condensateur.
